(19) Europäisches Patentamt
European Patent Office
Office européen des brevets

(11) EP 4 757 185 A1

(12) EUROPEAN PATENT APPLICATION

(43) Date of publication:
10.06.2026 Bulletin 2026/24

(51) International Patent Classification (IPC):
H03L 7/087 (2006.01)    H03L 7/091 (2006.01)
H03L 7/10 (2006.01)

(21) Application number: 25219838.7

(22) Date of filing: 01.12.2025

(52) Cooperative Patent Classification (CPC):
H03L 7/087; H03L 7/091; H03L 7/103;
H03L 2207/06; H03L 2207/50

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 05.12.2024 US 202418969788

(71) Applicant: NXP USA, Inc.
Austin, TX 78735 (US)

(72) Inventors:
• MOEHLMANN, Ulrich
5656AG Eindhoven (NL)
• MEIER, Jonas
5656AG Eindhoven (NL)

(74) Representative: Schwarzweller, Thomas
NXP Semiconductors Germany GmbH
Intellectual Property Group
Beiersdorfstraße 12
22529 Hamburg (DE)

(54) LOW-LATENCY SUBSAMPLING BANG-BANG DIGITAL PHASE-LOCKED LOOP

(57) An apparatus, such as a subsampling phase locked loop (PLL), includes a digitally controlled oscillator (DCO), a digital phase detector, and a digital filter. The DCO generates a first signal having a phase based on a second signal provided to the DCO. The digital phase detector generates a third signal that represents a phase offset between a reference clock signal and the first signal. The digital filter generates the second signal by filtering out high-frequency fluctuations in the third signal.

FIG. 1

EP 4 757 185 A1

**Description**

BACKGROUND

Phase-locked loops (PLLs) are control systems that receive an input signal and generate an output signal that has a phase that is fixed relative to the phase of the input signal. A PLL can be used to implement functionality such as clock synchronization, demodulation, frequency synthesis, clock multipliers, and signal recovery from noisy communication channels. PLLs are therefore implemented in many signal processing applications. For example, a PLL can provide signals with a stable phase to circuits used in radio, wireless communication, radar, microprocessors, and grid-tie converters. The components used to construct a PLL typically generate noise in the output signal, which can have a negative impact on the performance of the PLL.

BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.

FIG. 1 illustrates a processing system that includes a subsampling phase-locked loop (PLL), according to some embodiments.

FIG. 2 illustrates a plot of a signal that is generated by a digitally controlled oscillator (DCO) and a plot of an error function for sampling by a digital bang-bang phase detector, according to some embodiments.

FIG. 3 illustrates a plot of an expected value of an output of a digital bang-bang phase detector that is sampling a signal generated by a DCO in a PLL, according to some embodiments.

FIG. 4 illustrates a plot of quantization error that is generated by the digital bang-bang phase detector, according to some embodiments.

FIG. 5 illustrates a plot of phase noise contributions in a PLL for an optimally selected bandwidth, according to some embodiments.

FIG. 6 illustrates a plot of phase noise contributions in a PLL with a low bandwidth that is less than optimal, according to some embodiments.

FIG. 7 illustrates a plot of phase noise contributions in a PLL with a high bandwidth that is larger than optimal, according to some embodiments.

FIG. 8 illustrates a plot of the phase noise impact for different latencies, according to some embodiments.

FIG. 9 illustrates a processing system that includes a subsampling digital bang-bang PLL connected to a frequency locked loop (FLL), according to some embodiments.

FIG. 10 illustrates a circuit for performing a loop update, according to some embodiments.

DETAILED DESCRIPTION

A conventional analog PLL circuit includes a phase detector, a loop filter, and a voltage-controlled oscillator (VCO). In operation, the phase detector receives a reference signal and the goal of the PLL is to lock the phase of an output signal generated by the VCO to the phase of the reference signal. The output signal is fed back through a divider to the phase detector, which compares the phase of the (divided) output signal to the phase of the input reference signal. The phase detector generates a voltage that is proportional to a phase difference between the two signals, *i.e.* the time difference between the related edges in case of rectangular signals or the time difference between the related zero crossings in case of a sine signal. For example, the phase detector can generate a negative voltage to slow the VCO if the phase of the output signal leads the phase of the input reference signal and a positive voltage to speed up the VCO if the output signal lags the input reference signal. The amplitude of the voltage generated by the phase detector is proportional to the magnitude of the phase difference between the two signals. The loop filter is a low pass filter that stabilizes the voltage by filtering out high-frequency components. The VCO receives the filtered voltage and modifies the phase of its output signal based on the signal received from the loop filter. For example, the VCO speeds up to advance the phase of the output signal in response to the positive voltage indicating that the output signal lags the input reference signal and, conversely, the VCO slows down in response to the negative voltage indicating that the output signal leads the input reference signal.

Many applications, including radio and radar applications, benefit from the use of PLLs that have low in-band phase noise. As used herein, the term "in-band" refers to frequencies below the cutoff frequency of the overall phase transfer function of the PLL. The phase transfer function attenuates out-of-band signals above the cutoff frequency and is transparent to in-band signals below the cutoff frequency. Phase noise typically is produced by the reference clock signal provided to the phase detector in the PLL, the VCO, the loop filter, time-to-digital (TDC) and digital-to-time (DTC) converters, and a charge pump that is typically included to control voltages of the signals in the PLL. The in-band phase noise produced at the output of the PLL by the noise in the reference clock signal is equal to a product of the reference clock signal noise and a ratio of the reference clock frequency to the VCO frequency. In the case of an analogue subsampling PLL, the gain of the phase detector and corresponding loop gain can be relatively large, which may require incorporating large loop filter capacitors to provide sufficient phase margin for a stable loop. Large loop filter capacitors are, however, difficult to implement in an integrated design. Instead, a pulser can be used to limit the time that current from the charge pump is applied to the loop filter to a fraction of the reference time interval of the phase detector. Implementing a pulsed current in this manner often requires larger resistor values in the loop filter, which can degrade the phase noise performance by their noise contribution.

A subsampling bang-bang digital PLL improves phase noise performance by reducing phase noise generated by the phase detector and loop filter as well as eliminating components including the charge pump, TDC/DTC, and frequency divider that generate noise or latency in a conventional PLL. The subsampling bang-bang digital PLL includes a digital phase detector, a digital loop filter, and a digitally controlled oscillator (DCO) instead of a VCO. As used herein, the term "subsampling" refers to a PLL that includes a phase detector that directly samples the output signal generated by the oscillator at times indicated by a reference clock signal. Thus, a subsampling PLL does not require or include a divider in the feedback path from the VCO to the phase detector. The phrase "bang-bang" refers to a digital phase detector that generates an output of +1 (or some other fixed positive value) in response to the sampled output of the DCO being greater than zero and generates an output of -1 (or some other fixed negative value) in response to the sampled output of the DCO being less than zero. Depending on the implementation, the digital phase detector can provide an output of +1 or -1 in response to the sampled output being equal to zero. Phase noise (jitter) in the reference clock signal creates a statistical distribution of sampled phases that varies continuously from +1 to -1 and is referred to as an error function. The phase detector samples the phase of the output signal at sampling times determined by the reference clock signal and therefore samples points in the error function. Consequently, there is a first probability that the phase detector samples +1 and a second probability that the phase detector samples -1. The first and second probabilities are determined by the phase offset between the reference clock signal and the DCO signal and their sum is one. The phase detector introduces quantization noise equal to the difference between the actual output of the phase detector (e.g., +1 or -1) and the value of the error function at the phase offset. The quantization noise typically contributes a few decibels (dB) to the in-band phase noise, which is far less than the level of noise in conventional PLLs. Furthermore, conventional phase detectors include a TDC that contributes thermal noise, which is not generated by the digital phase detector.

The digital phase detector provides a digital signal representing the phase offset (*e.g.,* +1 or -1) to the digital loop filter, which filters out high-frequency spectral components in the digital signal. The DCO receives the filtered digital signal and modifies the phase of its output signal based on the signal received from the digital loop filter. In some embodiments, the digital loop filter is configured so that the bandwidth of the subsampling bang-bang digital PLL corresponds to a minimum in the phase noise or jitter. As discussed herein, the subsampling bang-bang digital PLL generates less phase noise than a conventional PLL. Furthermore, the subsampling bang-bang digital PLL can support larger bandwidths than the conventional PLL. One drawback is that the subsampling bang-bang digital PLL can lock to the phase of any harmonic of the reference clock signal. To address this issue, a frequency locked loop (FLL) can be connected to the DCO and used to hold the oscillator frequency of the DCO within a catching range of a desired harmonic of the reference clock signal. As used herein, the term "catching range" refers to a range of frequencies around a desired harmonic frequency within which the subsampling bang-bang digital PLL locks the phase of the output signal to the phase of the desired harmonic frequency. A typical catching range for a reference frequency, $f_{ref}$, is $f_{DCO} \pm f_{ref}/2$. Control of the DCO switches from FLL mode to the subsampling ADPLL mode when the frequency offset is within the catching range of the ADPLL which may be limited to a smaller interval than $\pm \dfrac{f_{ref}}{2}$ by the loop configuration. Settling time can be reduced by reducing the frequency offset towards zero. In some embodiments, the FLL remains active or is activated after predetermined time intervals to monitor the status of the ADPLL. In some embodiments, the FLL is operational or activated in response to a frequency difference between the frequency of the reference clock signal and the frequency of the DCO exceeding a threshold frequency difference that corresponds to the catching range of the frequency of the reference clock signal.

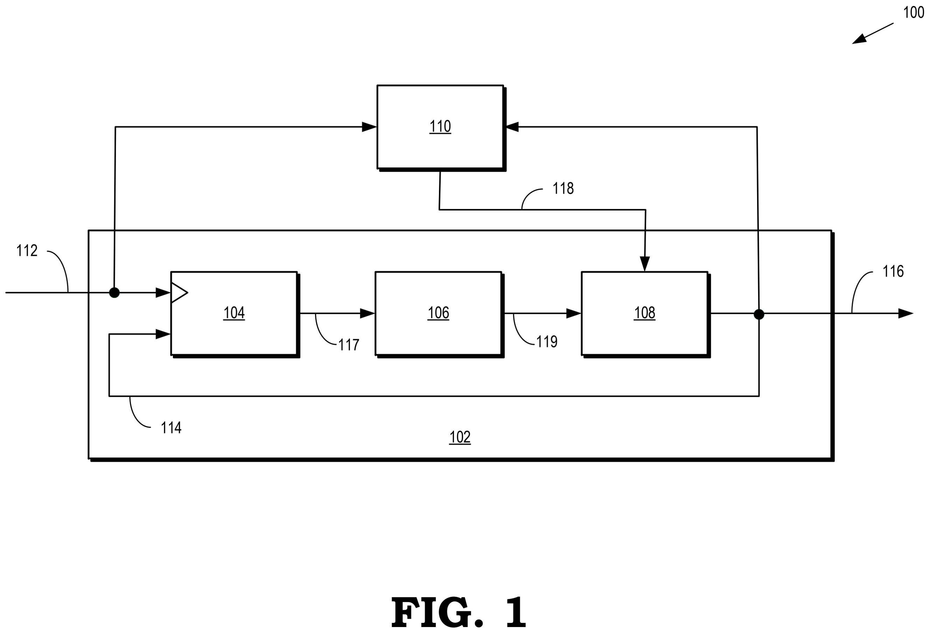

FIG. 1 illustrates a processing system 100 that includes a subsampling phase-locked loop (PLL) 102, according to some embodiments. The subsampling PLL 102 includes a phase detector 104, a loop filter 106, and a DCO 108. In the illustrated embodiment, the subsampling PLL 102 is connected to a frequency locked loop (FLL) 110. The phase detector 104, the loop filter 106, the controlling of the DCO 108, and the FLL 110 are implemented in the digital domain. Information is therefore processed in, and conveyed between, the phase detector 104, the loop filter 106, the DCO 108, and the FLL 110 as digital information, *e.g.,* bits, bytes, words, *etc.* The DCO 108 operates in the analogue domain.

The phase detector 104 is implemented as a "bang-bang" phase detector that generates output in the form of a digital word that represents a value of +1 or -1 based on a sampled value of an input signal. The phase detector 104 receives a reference clock signal 112 and samples a feedback signal 114 (also referred to herein as a second signal 114) on each cycle of the reference clock signal. In some embodiments, the phase detector 104 samples the feedback signal 114 on a rising edge or a falling edge of the reference clock signal 112. The phase detector 104 generates an output value of +1 in response to the sampled value of the feedback signal 114 being greater than zero and an output value of -1 in response to the sampled value of the feedback signal 114 being less than zero. Depending on the implementation, the phase detector 104 can generate an output value of +1 or -1 in response to the sampled value of the feedback signal 114 being equal to zero.

The loop filter 106 receives the output generated by the phase detector 104. The loop filter 106 has a low-pass characteristic and therefore filters out high-frequency spectral components in the signal received from the phase detector 104. As discussed herein, some embodiments of the loop filter 106 are configured so that the bandwidth of the subsampling PLL 102 corresponds to a minimum in the phase noise or jitter generated by the components of the subsampling PLL 102. The filtered signal generated by the loop filter 106 is provided to the DCO 108, which generates or modifies the phase or frequency of an output signal 116 (also referred to herein as a first signal 116) based on the filtered signal received from the loop filter 106.

The output signal 116 from the DCO 108 is fed back to the phase detector 104 as the feedback signal 114. Thus, the phase detector 104 directly samples the signal 116 as output from the DCO 108. The feedback path between the DCO 108 and the phase detector 104 does not include entities that modify the phase or frequency of the feedback signal 114. This contrasts with conventional, or "sampling," PLLs that include a frequency divider in the feedback path between the DCO 108 and the phase detector 104 to modify the frequency of the feedback signal 114. For example, the frequency divider can reduce the frequency of the feedback signal. The frequency divider, if present, could contribute phase noise and removing the frequency divider from the feedback path decreases the phase noise generated in the subsampling PLL 102. In some embodiments, partial frequency division is performed on the output signal 116, e.g., not to a reference level but some easier to handle frequency such as reducing the frequency of the output signal 116 by a factor of eight.

The subsampling PLL 102 can produce a lock condition for any frequency of the output signal 116 that is a harmonic of the frequency of the reference clock signal 112. The FLL 110 is therefore connected to the DCO 108 in a feedback loop that holds the frequency of the DCO 108 near a preferred harmonic of the frequency of the reference clock signal 112. In some embodiments, the FLL 110 holds the frequency of the DCO 108 within a catching range of the reference clock signal 112. The catching range for a reference frequency, $f_{ref}$, can be $f_{DCO} \pm f_{ref}/2$ or smaller interval around the desired harmonic of the reference signal which is defined by the loop configuration. In some embodiments, the FLL 110 compares the frequency of the reference clock signal 112 and the frequency of the output signal 116. For example, the FLL 110 can measure a difference between the frequency of the reference clock signal 110 and the frequency of the output signal 116. Based on the comparison, the FLL 110 generates a control signal 118 (also referred to herein as a fourth signal 118) that is provided to the DCO 108. A status of the FLL 110 can be stored when the frequency of the reference clock signal is within the catching range of the preferred harmonic and the PLL being switched to subsampling operation mode.

The subsampling PLL 102 can be operated in two modes that are distinguished by the control signal used by the DCO 108 to generate or modify the output signal 116. In the first mode, the DCO 108 receives a control signal 117 (also referred to herein as a third signal 117) generated by the phase detector 104 and the loop filter 106. The DCO 108 uses this control signal to generate or modify the output signal 116 based on phase differences between the feedback signal 114 and the reference clock signal 112. In the second mode, the DCO 108 receives a control signal generated by the FLL 110 and uses this control signal to generate or modify the output signal 116 based on frequency differences between the reference clock signal 112 and the output signal 116. The FLL 110 can be switched to idle or standby mode when the subsampling PLL 102 is operating in the first mode. However, in some embodiments, the FLL 110 can monitor the output signal 116 to detect disturbances in the output signal 116. For example, the FLL 110 can trigger a transition from the first mode to the second mode in response to detecting a change in the frequency of the output signal 116 that falls outside the catching range of the preferred harmonic of the reference clock signal 112.

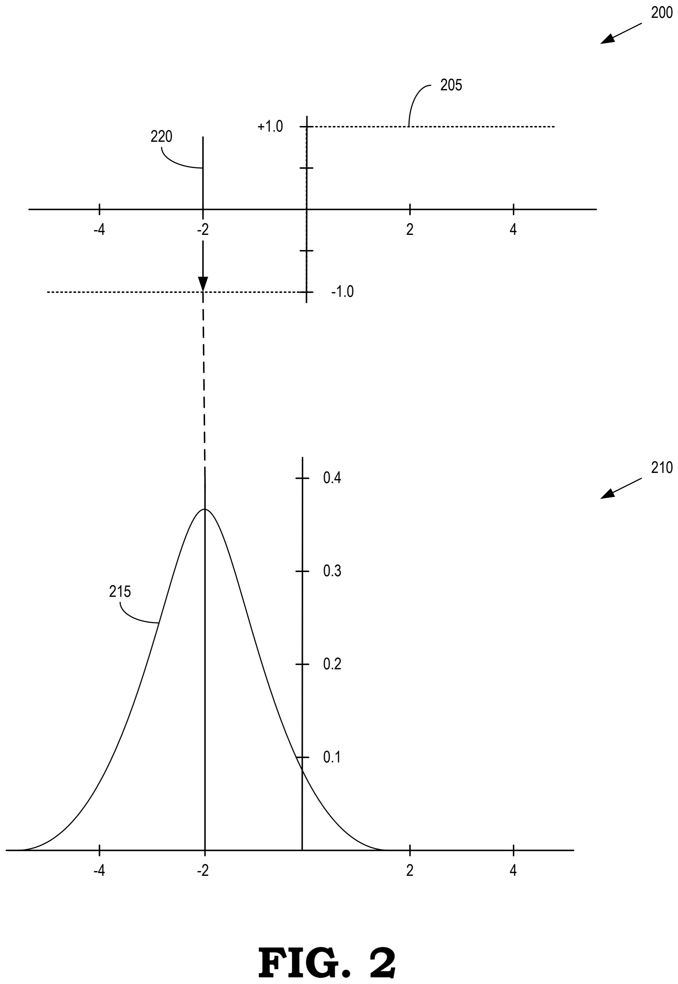

FIG. 2 illustrates a plot 200 of a signal 205 that is generated by a DCO and a plot 210 of an probability density function 215 for sampling by a digital bang-bang phase detector, according to some embodiments. The illustrated sampling method is performed by some embodiments of the phase detector 104 shown in FIG. 1. The horizontal axes of the plots 200, 210 indicate a phase offset between a reference clock signal and the signal 205 that is generated by the DCO. The vertical axis of the plot 200 indicates the probability for detection of a certain offset of the signal generated by the DCO, *e.g.,* the DCO generates a signal with a value of -1.0 at negative phases and the value of +1.0 at positive phases. If a value is detected on the negative side of the x-axis the output value is referred as -1 one and if a value is detected on the positive side then the value is referred as 1.

The digital bang-bang phase detector samples the signal 205 directly as output from the DCO and the timing of the sampling is determined by the phase offset between the reference clock signal and the signal 205. The digital bang-bang phase detector samples a value of -1.0 if the reference clock signal lags the signal 205 and the digital bang-bang phase detector samples a value of +1.0 if the reference clock signal leads the signal 205. In the illustrated embodiment, the digital bang-bang phase detector samples the signal 205 at a sampling point 220 that corresponds to a phase offset of -2 and so the sample value of the signal 205 is likely to be -1.0. However, phase noise in the reference clock signal introduces jitter into the timing of the sampling. Thus, the digital bang-bang phase detector can sample a value of +1.0 even though the reference clock signal lags the signal 205. Conversely, the digital bang-bang phase detector can sample a value of -1.0 even though the reference clock signal leads the signal 205.

The probability density function 215 indicates probabilities of sampling a value of +1.0 or -1.0 as a function of the actual phase offset between the reference clock signal and the signal 205. In the illustrated embodiment, the error function 215 has a peak at a phase offset of -2, which is the actual phase offset between the reference clock signal and the signal 205. However, jitter in the reference clock signal spreads the probability density function 215 over a range of phase offsets. The probability of sampling a value of -1.0 from the signal 205 for an actual phase offset of -2 is equal to the area under the error function 215 integrated over phase offsets from -∞ to 0.0. The probability of sampling a value of +1.0 from the signal 205 for an actual phase offset of -2 is equal to the area under the probability density function 215 integrated over phase offsets from 0.0 to ∞. Thus, the expected value of the sample value generated and output by the digital bang-bang phase detector varies continuously as a function of the phase offset.

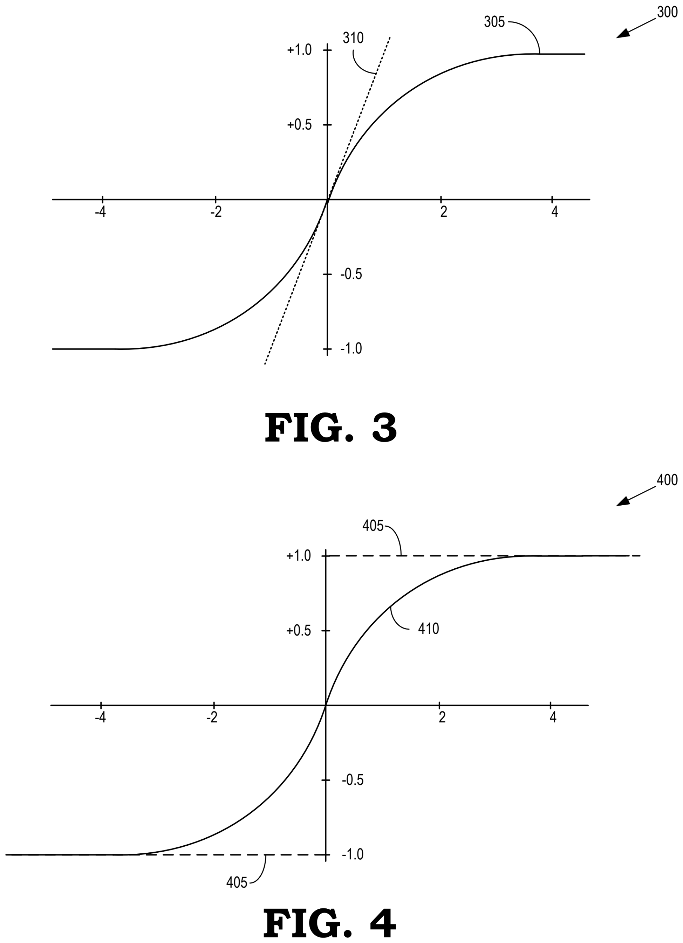

FIG. 3 illustrates a plot 300 of an expected value 305 of an output of a digital bang-bang phase detector that is sampling a signal generated by a DCO in a PLL, according to some embodiments. The horizontal axis of the plot 300 indicates a phase offset and the vertical axis of the plot 300 indicates the expected value 305, which varies from -1.0 to +1.0. The expected value 305 can be linearized at or near the operation point of the PLL (*e.g.,* at or near a phase offset of 0.0) using a Taylor approximation. A derivative 310 of the Taylor approximation of the expected value 305 at the operation point reflects the phase detector gain of the digital bang-bang phase detector, which can be calculated as:

$$kd_{BB-PD} = \frac{\Delta bbpd_{out,\exp ected}}{\Delta t} = \sqrt{\frac{2}{\pi}} \cdot \frac{1}{\sigma_{\Delta t}}$$

where $\Delta bbpd_{out,expected}$ is the expected value that is output from the digital bang-bang phase detector calculated from the probability density function and $\sigma_{\Delta t}$ is the jitter at the digital bang-bang phase detector. The jitter includes contributions from the reference clock jitter and the DCO jitter in closed loop mode. Smaller jitter contributions create larger phase detector gains, $kd_{BB-PD}$, and loop gains.

If the phase detector gain is $kd_{BB-PD}$, the open loop phase transfer function ($h_{bb,ol}$) can be expressed as:

$$h_{bb,ol}(s) = \frac{\varphi_{out}}{\Delta\varphi} = kd_{BB-PD} \cdot \frac{T_{ref}}{2\pi} \cdot LF(s) \cdot \frac{k_{DCO}}{s}$$

The closed loop transfer function ($h_{bb,cl}$) can be calculated from the open loop phase transfer function ($h_{bb,ol}$) and represented as:

$$h_{bb,cl} = \frac{\varphi_{out}}{\varphi_{in}} = \frac{h_{bb,ol}}{1 + h_{bb,ol}} = \frac{kd_{BB-PD} \cdot \dfrac{T_{ref}}{2\pi} \cdot LF(s) \cdot k_{DCO}}{s + kd_{BB-PD} \cdot \dfrac{T_{ref}}{2\pi} \cdot LF(s) \cdot k_{DCO}}$$

These equations imply that the reference period or time interval ($T_{ref}$) has an impact on the loop gain so that increasing the reference time interval, which decreases the reference frequency, increases the loop gain. Thus, the phase margin can be optimized, *e.g.*, by optimizing bandwidth, phase margin, jitter, *etc.*

If the reference phase noise and DCO phase noise are constant over the process, voltage, temperature and tuning range, it is only necessary to provide one optimized setting to the loop filter of the subsampling bang-bang phase detector and this setting should be sufficient. However, if the reference or DCO phase noise depends on one or more of these parameters, a calibration is needed to optimize the loop bandwidth. In some embodiments, calibration is performed using a production test that measures phase noise directly or by other methods that measure the bandwidth and perform a bandwidth calibration, *e.g.*, at start-up of the circuit.

FIG. 4 illustrates a plot 400 of quantization error that is generated by the digital bang-bang phase detector, according to some embodiments. The horizontal axis of the plot 400 indicates the phase offset and the vertical axis indicates the value 405 that is generated by the digital bang-bang phase detector. The generated value ranges from -1.0 at negative phase offsets to +1.0 at positive phase offsets. The plot 400 also includes an error function 410 generated by phase noise at the digital bang-bang phase detector. The quantization error produced by the digital bang-bang phase detector is determined by the difference between the value 405 and the error function 410. The total quantization error is equal to the integral of the difference from $-\infty$ to $+\infty$.

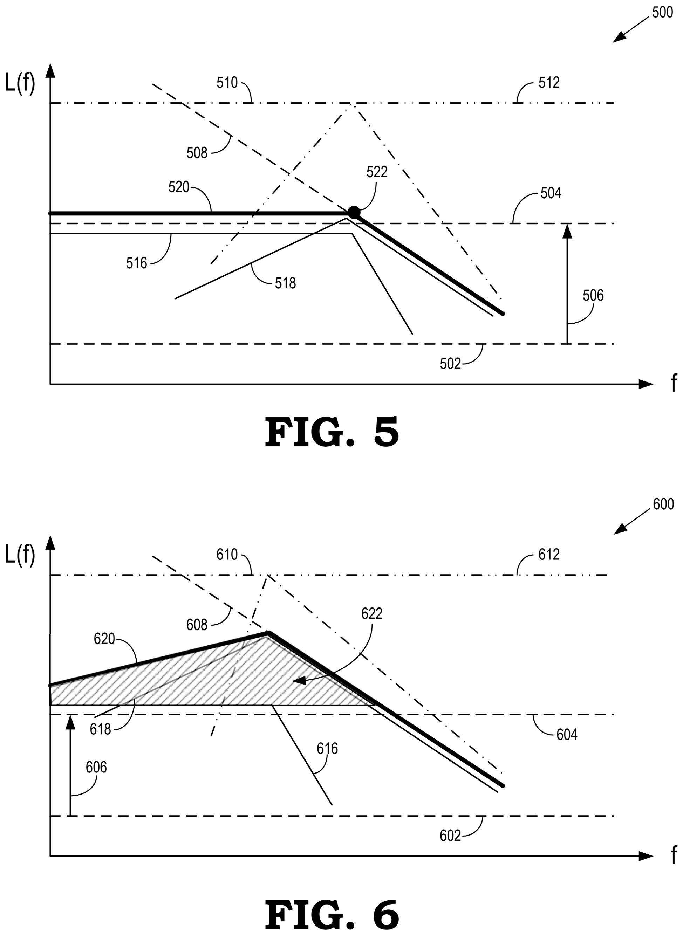

FIG. 5 illustrates a plot 500 of phase noise contributions in a PLL for an optimally selected bandwidth, according to some embodiments. The horizontal axis of the plot 500 indicates frequency, *f*, on a logarithmic scale and the vertical axis of the plot 500 indicates phase noise, *L(f)*, on a logarithmic scale.

The curve 502 represents the unfiltered phase noise for the reference clock signal and the curve 504 represents the unfiltered phase noise amplified by the gain 506 determined by the ratio of the oscillator frequency to the reference clock frequency, *e.g.*, the value of $20 - \log_{10}\left(\dfrac{f_{osc}}{f_{ref}}\right)$. The curve 508 represents the unfiltered oscillator phase noise. The curve 510 represents the low pass filter characteristic of the PLL, which is applied to the amplified reference clock phase noise (curve 504). The curve 512 represents the high-pass filter characteristics that are applied to the oscillator phase noise (curve 508). The curve 516 represents the filtered reference clock phase noise and the curve 518 represents the filtered oscillator phase noise. The total phase noise produced by the PLL is represented by the curve 520.

For a given level of the reference clock phase noise (curves 502, 504) and the oscillator phase noise (curve 508), an optimum bandwidth for minimum jitter can be found at the point 522, which is close to the offset frequency where the reference phase noise (curve 504) multiplied with the ratio of the oscillator frequency to the reference clock frequency $(20 - \log_{10}\left(\dfrac{f_{osc}}{f_{ref}}\right))$ intersects the oscillator phase noise characteristic. For higher frequencies, the reference phase noise (curves 502, 504) is suppressed by low pass characteristic of the loop filter. In the illustrated embodiment, the loop filter attenuates the reference phase noise at a higher order (*e.g.*, -40 dB/dec) than the oscillator phase noise characteristic (*e.g.*, -20 dB/dec), so that the oscillator phase noise (curve 508) dominates outside the loop bandwidth. The oscillator phase noise (curve 508) is overcompensated by the high pass characteristic of the loop for this component so that in the illustrated embodiment only the reference phase noise contribution remains for in-band phase noise.

FIG. 6 illustrates a plot 600 of phase noise contributions in a PLL with a low bandwidth that is less than optimal, according to some embodiments. The horizontal axis of the plot 600 indicates frequency, *f*, on a logarithmic scale and the vertical axis of the plot 600 indicates phase noise, *L(f)*, on a logarithmic scale.

The curve 602 represents the unfiltered phase noise for the reference clock signal and the curve 604 represents the unfiltered phase noise amplified by the gain 606 determined by the ratio of the oscillator frequency to the reference clock frequency, *e.g.*, the value of $20 - \log_{10}\left(\dfrac{f_{osc}}{f_{ref}}\right)$. The curve 608 represents the unfiltered oscillator phase noise. The curve 610 represents the low pass filter characteristic of the PLL that is applied to the amplified reference clock phase noise (curve 604). The curve 612 represents the high-pass filter characteristics of the PLL that is applied to the oscillator phase noise (curve 608). Relative to the corresponding curves 510, 512 shown in FIG. 5, the curve 610 indicates that the low pass filter characteristic attenuates signals beginning at a lower frequency than the low pass filter characteristic of the curve 510 shown in FIG. 5. The curve 616 represents the filtered reference clock phase noise and the curve 618 represents the filtered oscillator phase noise. The total phase noise produced by the PLL is represented by the curve 620.

In the embodiment shown in FIG. 6, the bandwidth of the PLL determined by the cutoff frequency of the low pass characteristic of the PLL is lower than the optimal value shown in FIG. 5. Thus, the oscillator contribution to the phase noise (indicated by the curve 618) is suppressed at lower frequencies by the high pass filter characteristic for this component but at higher levels than the reference phase noise contribution (as indicated by the curve 616). The oscillator is therefore the dominant contributor to the phase noise and jitter of the PLL. The hatched area 622 indicates the difference between the total phase noise for the embodiment shown in FIG. 6 and the (relatively smaller) total phase noise of the embodiment shown in FIG. 5.

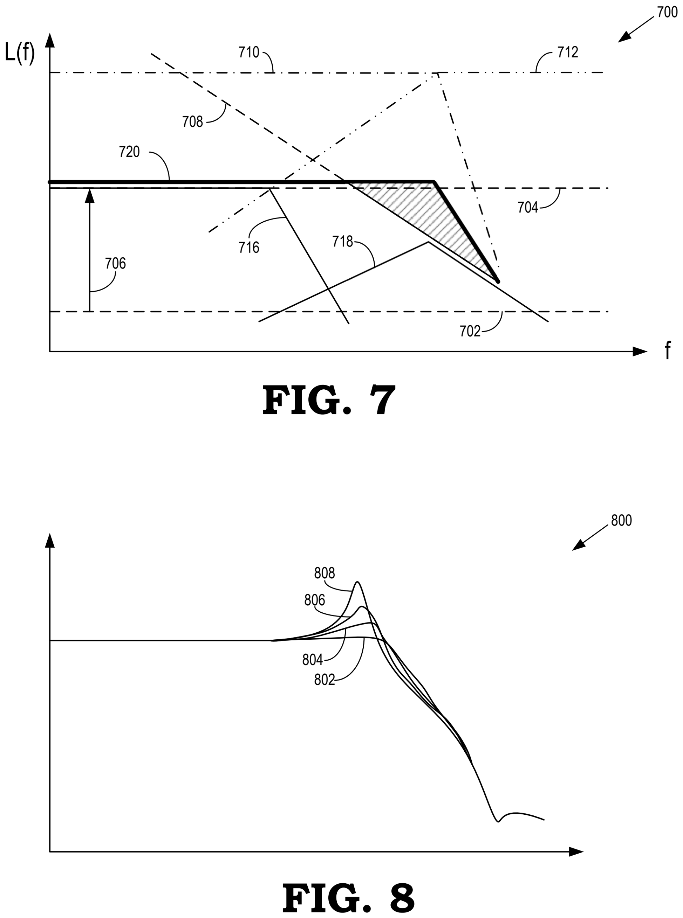

FIG. 7 illustrates a plot 700 of phase noise contributions in a PLL with a high bandwidth that is less than optimal, according to some embodiments. The horizontal axis of the plot 700 indicates frequency, *f*, on a logarithmic scale and the vertical axis of the plot 700 indicates phase noise, *L(f)*, on a logarithmic scale.

The curve 702 represents the unfiltered phase noise for the reference clock signal and the curve 704 represents the unfiltered phase noise amplified by the gain 706 determined by the ratio of the oscillator frequency to the reference clock frequency, *e.g.*, the value of $20 - \log_{10}\left(\dfrac{f_{osc}}{f_{ref}}\right)$. The curve 708 represents the unfiltered oscillator phase noise.

The curve 710 represents the low pass filter characteristic of the PLL that is applied to the amplified reference clock phase noise (curve 704). The curve 712 represents the high-pass filter characteristics of the PLL that is applied to the oscillator phase noise (curve 708). Relative to the corresponding curves 510, 512 shown in FIG. 5, the curve 710 indicates that the low pass filter characteristic attenuates signals beginning at a higher frequency than the low pass filter characteristic of the curve 510 shown in FIG. 5. The curve 716 represents the filtered reference clock phase noise and the curve 718 represents the filtered oscillator phase noise. The total phase noise produced by the PLL is represented by the curve 720.

In the embodiment shown in FIG. 7, the bandwidth of the PLL determined by the cutoff frequency of the low pass characteristic of the PLL is higher than the optimal value shown in FIG. 5. Thus, the oscillator contribution to the phase noise (indicated by the curve 718) is suppressed to lower levels than the reference phase noise contribution (as indicated by the curve 716), but the low pass filtering of the reference phase noise contribution (as indicated by the curve 716) is done at larger frequencies. The higher cutoff frequency leads to the reference phase noise contribution (as indicated by the curve 716) dominating the phase noise contribution and jitter. The hatched area 722 indicates the difference between the total phase noise for the embodiment shown in FIG. 7 and the (relatively smaller) total phase noise of the embodiment shown in FIG. 5.

In some embodiments, a large loop bandwidth can reduce in-band phase noise considerably especially if the other components are already on the edge of what can be designed in the available technology. For a given reference phase noise level and a given phase noise produced by the oscillator, there is an optimum bandwidth of the system that results in the overall phase noise or jitter respectively being at or near a minimum. The optimum bandwidth is at a larger loop bandwidth for larger oscillator phase noises or lower reference phase noises.

Subsampling or sampling PLLs can be designed to provide large bandwidths. In both cases, the loop gain can be large to support provision of a large bandwidth in the PLL. Furthermore, configuring the phase detector to produce a large gain, and correspondingly large loop gain, contributes to reductions in the phase noise contribution of a charge pump, if present. All-digital PLLs can also be used to provide large loop bandwidths. The noise contributions to an all-digital PLL are typically dominated by the reference phase noise, oscillator phase noise, and in some cases quantization noise contributions. However, the potential bandwidth of the all-digital PLL can be limited by latency. For example, if the bandwidth of the all-digital PLL is too large, latency in the feedforward and feedback paths has a significant impact on the phase noise characteristic of the all-digital PLL.

FIG. 8 illustrates a plot 800 of the phase noise impact for different latencies, according to some embodiments. The horizontal axis of the plot 800 indicates frequency, $f$, on a logarithmic scale and the vertical axis of the plot 800 indicates phase noise, $L(f)$, on a logarithmic scale.

Latency can impact the overall phase noise characteristic significantly and hence the latency affects jitter as well. In the illustrated embodiment, the curve 802 represents the phase noise as a function of frequency for a latency of 0. The curve 804 represents the phase noise as a function of frequency for a latency of 0.5. The curve 806 represents the phase noise as a function of frequency for a latency of 1.0. The curve 808 represents the phase noise as a function of frequency for a latency of 1.5. The total phase noise increases by 13 dB as the latency changes from 0 to 1.5 and the jitter doubles because the largest impact to jitter is due to variations in the loop bandwidth.

Some embodiments of the subsampling digital bang-bang PLL described herein can address the latency issue of conventional all-digital PLL systems. For example, the oscillator signal is sampled directly (*e.g.*, as output from the DCO) in subsampling architectures so there is no latency in the feedback path. Moreover, the loop filter can be designed to avoid or reduce or eliminate latency in the feedforward path. Some embodiments of the subsampling digital bang-bang PLL can be configured with higher reference frequencies.

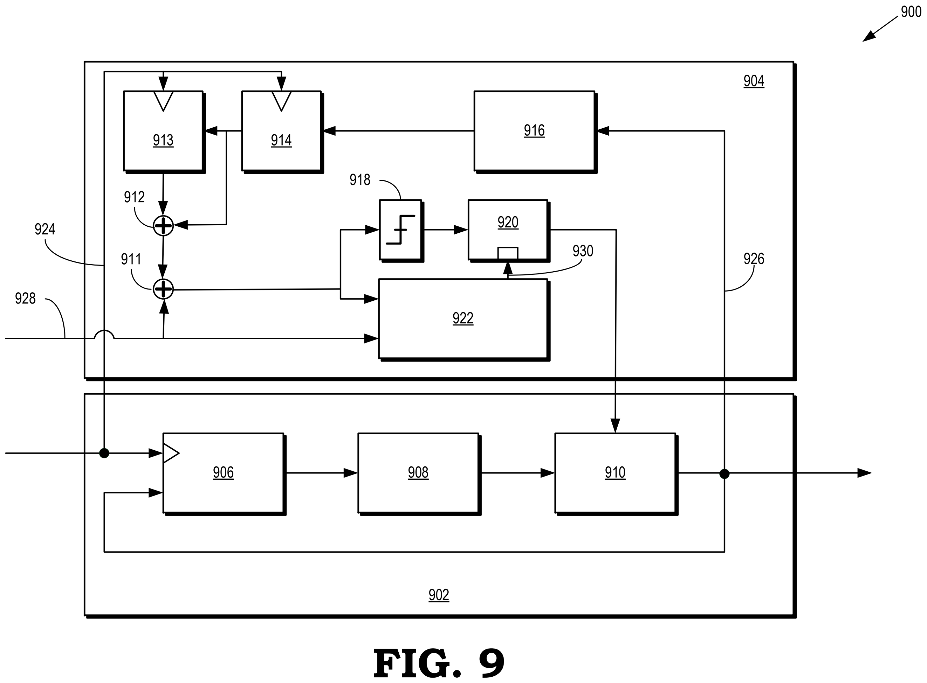

FIG. 9 illustrates a processing system 900 that includes a subsampling digital bang-bang phase-locked loop (PLL) 902 connected to a frequency locked loop (FLL) 904, according to some embodiments. The subsampling digital bang-bang PLL 902 includes a bang-bang phase detector 906, a loop filter 908, and a DCO 910 and these entities operate as discussed herein. The subsampling digital bang-bang PLL 902 and the FLL 904 are implemented in some embodiments of the processing system 100 in FIG. 1.

In the illustrated embodiment, the FLL 904 includes adders 911, 912 and registers 913, 914. The FLL 904 also includes a counter 916, a quantizer 918, and a loop filter 920. A controller 922 and the FLL 904 is used to selectively activate the loop filter, as discussed herein. In operation, the FLL 904 receives the reference clock signal 924 and the signal 926 generated by the DCO 910. Some embodiments of the FLL 904 and the subsampling digital bang-bang PLL 902 operate in two modes: an FLL control mode and a phase detector control mode. In the phase detector control mode, the DCO 910 receives a control signal generated by the bang-bang phase detector 906 and the loop filter 908. The control signal is used to generate or modify operation of the DCO 910, as discussed herein. In the FLL control mode, the DCO 910 receives a control signal generated by the FLL 904 and the DCO 910 modifies its behaviour based on the control signal, as discussed herein. Some embodiments of the FLL 904 can be switched to idle or standby mode during the phase detector control mode. The FLL 904 can monitor the output signal 926 to detect disturbances in the output signal 926, as discussed herein.

In some embodiments, subsampling digital bang-bang PLL 902 switches from the phase detector control mode to the FLL control mode at startup of the subsampling digital bang-bang PLL 902 or in response to changing from one frequency to another frequency. In FLL control mode, the frequency of the signal 926 is measured by measuring the number of pulses within a count window (as determined using the counter 916). The count window can correspond to a reference clock interval. The result is provided to the registers 913, 914 as a feedback word (FBW). The FBW is compared to a frequency control word (FCW) 928 that is provided to the FLL 904. The FCW 928 represents an expected number of DCO clock pulses or intervals within a count window such as a reference clock interval. The controller 922 determines the difference between FCW 928 and the FBW, which indicates a difference ($\Delta f$) between the actual and the desired oscillator frequency. The controller 922 then provides a signal 930 representing the difference ($\Delta f$) to update the loop filter 920. In some embodiments, the quantizer 918 updates the DCO 910 by discrete frequency steps: a step up if the DCO 910 was found to be too slow or a step down if the DCO 910 was found to be too fast. Implementing the quantizer 918 can result in faster settling of the system. The frequency resolution of the frequency measurement can be increased by averaging or by using larger measurement intervals. If a larger measurement interval is chosen, the counter samples are not taken at the time intervals indicated by the reference clock signal 924 but at intervals equal to a multiple of the time intervals indicated by the reference clock signal 924.

Transitions between the FLL control mode and the phase detector control mode can be triggered by satisfying different criteria. The FLL 904 retains control of the DCO 910 until the frequency offset ($\Delta f$) between actual and desired frequency is smaller than the catching range of the subsampling digital bang-bang PLL 902. Once that condition is fulfilled, control of the loop is switched from the FLL control mode to the phase detector control mode.

In a first embodiment, the transition from the FLL control node to the phase detector control mode occurs a fixed time interval after the system transitions into the FLL control mode from the phase detector control mode. The time interval can be determined based on whether the loop is updated linearly or discreetly. The maximum possible tuning range and a potential safety margin can also be considered when determining the time interval.

In a second embodiment, the transition from the FLL control mode to the phase detector control mode is determined based on the actual frequency difference. For example, the controller 922 can determine the frequency offset ($\Delta f$) and switch to the phase detector control mode in response to the frequency offset ($\Delta f$) being smaller than the catching range of the subsampling digital bang-bang PLL 902. The maximum value of the catching range is $\pm \frac{f_{ref}}{2}$, although the actual catching range can be smaller than this due to characteristics of the loop filter 908 and the bandwidth of the loop. The frequency step size of the DCO 910 can be smaller than the catching range of the subsampling digital bang-bang PLL 902.

In a third embodiment, the system implements a dead zone that is smaller than the catching range of the subsampling digital bang-bang PLL 902, which takes over control and settles in the phase detector control mode automatically without further input from the controller 922.

The FLL loop status can be frozen while the phase detector control mode is active. However, in some embodiments, the FLL loop can still monitor the frequency of the signal 926 to detect disturbances that may switch the loop to other harmonics of the reference clock signal 924 or cause the subsampling ADPLL to get out of lock. Measurements used to monitor the frequency of the signal 926 can happen concurrently or continuously with the phase detector control mode, at intervals determined based on an error detection time requested by the system, or at other time intervals. If the frequency difference $\Delta f$ exceeds the threshold or the dead zone, the FLL 904 is reactivated by switching to the FLL control mode and provides control signals to the DCO 910 until the system returns to lock. For example, the FLL 904 can be reactivated in response to a severe disturbance in the loop caused by a brownout, as well as in response to changing the FCW 928.

Some embodiments of the subsampling digital bang-bang PLLs described herein avoid, reduce, or eliminate phase noise contributions from entities such as a charge pump or an analog loop filter that are present in conventional subsampling or sampling PLLs. The subsampling digital bang-bang PLLs receive noise contributions from DCO quantization and quantization noise from a bang-bang phase detector. Some embodiments of the DCO are configured to reduce the DCO quantization noise to a negligible level, *e.g.*, using noise shaping by the means of $\Delta\Sigma$-modulation. The bang-bang quantization noise is dominated by the reference phase noise, which is typically the same order of magnitude as the reference phase clock noise and can have a marginal impact to the in-band phase noise. If the phase noise of the reference clock is improved the in-band phase noise will be correspondingly improved. The in-band phase noise level that can be achieved with a subsampling digital bang-bang PLL is lower than that of a conventional subsampling PLL under comparable conditions.

In some embodiments, the latency of a subsampling digital bang-bang PLL can be kept small because there is no latency in the feedback path and the feedforward path latency can be maintained at a negligibly small level. The effects of sampling along the direct path including the bang-bang phase detector can be controlled to maintain alignment of the DCO updates and avoid glitches.

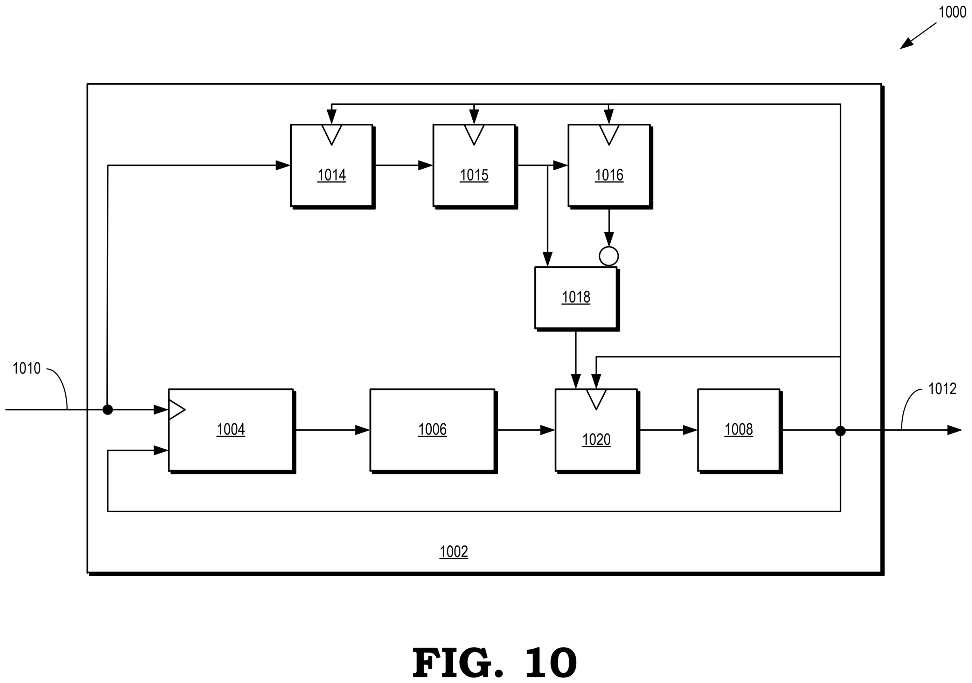

FIG. 10 illustrates a circuit 1000 for performing a loop update, according to some embodiments. The circuit 1000 is implemented in a subsampling PLL 1002 such as some embodiments of the subsampling PLL 102 shown in FIG. 1 and the subsampling digital bang-bang PLL 902 shown in FIG. 9.

The subsampling PLL 1002 includes a phase detector 1004, a loop filter 1006, and a DCO 1008, which operate as discussed herein. The phase detector 1004 receives a reference clock signal 1010 in the DCO 1008 generates an output signal 1012. The circuit 1000 also includes a set of flip-flops 1014, 1015, 1016, which are collectively referred to herein as "the flip-flops 1014-1016." The reference clock signal 1010 is provided as input to the flip-flop 1014 and the output signal 1012 is used as an update signal for the flip-flops 1014-1016. On each cycle of the output signal 1012, the value stored in the flip-flop 1014 is copied to the flip-flop 1015 and the value stored in the flip-flop 1015 is copied to the flip-flop 1016. The output of the flip-flop 1015 and the inverse of the output of the flip-flop 1016 are provided to an AND gate 1018. The value produced by the AND gate 1018 is provided to the register 1020, which receives an enable signal or activation signal from the output signal 1012. In some embodiments, the AND gate 1018 is used for rising or falling edge detection.

In the illustrated embodiment, the loop filter 1006 is configured to reduce or eliminate latency. In this case the amount of delay introduced by the DCO 1008 depends on the propagation delay in the feedforward path including the setup time (plus a margin) of the register 1020 that updates the DCO 1008. An update pulse can be derived from the reference clock signal 1010 by a rising edge detection with a clock that is derived from the DCO 1008. This can be the DCO clock itself or a divided clock. Depending on the ratio of the frequency of the signal 1012 generated by the DCO 1008 and the reference clock signal 1010, the effective latency can be kept to a fraction of the reference period so that latency does not impact the overall loop characteristic. The flip-flops 1014, 1015 are included in front of the rising edge detection performed at the AND gate 1018 to avoid metastability.

The illustrated embodiment of the subsampling PLL 1002 does not include dividers in the feedback path. However, in some embodiments one or more dividers may be implemented in the feedback path if output clocks are required to be phase aligned to the reference clock signal 1010. If the divided DCO frequency is higher than the frequency of the reference clock signal 1010, the resulting system will have the characteristics of a subsampling digital bang-bang PLL. The divider effectively reduces the DCO gain in the loop. In some embodiments, an FLL may not be necessary to lock to subsampling BB-ADPLL if the resulting frequency tuning range of the divided signal is smaller than $\pm \dfrac{f_{ref}}{2}$. However, the FLL may be needed to accelerate the lock process. If the output frequency of the divider is comparable to the frequency of the reference clock signal 1010, the system approximates a sampling digital bang-bang PLL except that in case of the subsampling digital bang-bang PLL the reference clock is sampling the divider signal while the sampling digital bang-bang PLL samples the reference clock with divided signal. The performance can be expected to be similar or identical.

In some embodiments, holding, using the FLL and the DCO, the output frequency of the first signal within a catching range of the reference frequency. In some embodiments modifying the output frequency of the first signal comprises modifying the output frequency of the first signal in response to the fourth signal provided by the FLL in a first mode of operation, and wherein generating the first signal comprises generating the first signal having the phase determined based on the second signal provided to the DCO in a second mode of operation. Some embodiments further comprise: activating the FLL in the first mode of operation in response to a frequency difference between the reference frequency and the output frequency of the first signal exceeding a threshold frequency difference that corresponds to the catching range.

The disclosure further extends to a subsampling phase locked loop (PLL) comprising: a digitally controlled oscillator (DCO) configured to generate a first signal having a phase determined based on a second signal provided to the DCO; a quantizer configured to generate a third signal that represents a value of +1 in response to a sampled value of the first signal having a value greater than zero and a value of -1 in response to the sampled value of the first signal having a value less than zero; and a loop filter configured to generate the second signal in response to receiving the third signal from the quantizer, wherein the loop filter is a low pass filter.

In some embodiments, the subsampling PLL of claim 19, further comprises: a frequency locked loop (FLL) configured to provide a fourth signal to the DCO, wherein the fourth signal represents a difference between a reference frequency of a harmonic of a reference clock signal and an output frequency of the first signal generated by the DCO, and wherein the DCO is configured to modify the output frequency of the first signal based on the fourth signal so that the output frequency remains within a catching range of a reference frequency of a harmonic of the reference clock signal.

Note that not all the activities or elements described above in the general description are required, that a portion of a specific activity or device may not be required, and that one or more further activities may be performed, or elements included, in addition to those described. Still further, the order in which activities are listed is not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the embodiments disclosed above may be altered or modified and all such variations are considered within the scope of the disclosed subject matter. Accordingly, the protection sought herein is set forth in the claims below.

**Claims**

1.  An apparatus comprising:

    a digitally controlled oscillator, DCO, configured to generate a first signal having a phase based on a second signal provided to the DCO;
    a digital phase detector configured to generate a third signal that represents a phase offset between a reference clock signal and the first signal; and
    a digital filter configured to generate the second signal by filtering out spectral components in the third signal.

2.  The apparatus of claim 1, wherein the digital phase detector is configured to generate the third signal representing a fixed positive value in response to the first signal generated by the DCO representing a value greater than zero, and wherein the digital phase detector is configured to generate the third signal representing a fixed negative value in response to the first signal generated by the DCO representing a value less than zero.

3.  The apparatus of claim 2, wherein the digital phase detector is configured to receive the first signal as output from the DCO.

4.  The apparatus of claim 3, wherein the digital phase detector is configured to generate quantization noise representative of a difference between the value represented by the third signal and a value of a probability density function at the phase offset, and wherein the probability density function represents a statistical distribution of sampled phases determined based on phase noise in the reference clock signal.

5.  The apparatus of any preceding claim, wherein the digital filter is configured such that the apparatus has a bandwidth that corresponds to a minimum in phase noise of the apparatus.

6.  The apparatus of any preceding claim, further comprising:

    a frequency locked loop, FLL, connected to the DCO and configured to generate a fourth signal that represents a difference between a reference frequency of a harmonic of the reference clock signal and an output frequency of the first signal generated by the DCO, and
    wherein the DCO is configured to modify the output frequency of the first signal based on the fourth signal.

7.  The apparatus of claim 6, wherein the FLL and the DCO are configured to hold the output frequency of the first signal within a catching range of the reference frequency.

8.  The apparatus of claim 7, wherein the DCO is configured to modify the output frequency of the first signal in response to the fourth signal provided by the FLL in a first mode of operation, and wherein the DCO is configured to generate the first signal having the phase determined based on the second signal provided to the DCO in a second mode of operation.

9.  The apparatus of claim 8, wherein the FLL is operational in the first mode of operation in response to a frequency difference between a harmonic of the reference frequency and the output frequency of the first signal exceeding a threshold frequency difference that corresponds to the catching range.

10. A method comprising:

   generating, at a digitally controlled oscillator, DCO, a first signal having a phase based on a second signal provided to the DCO;
   generating, at a digital phase detector, a third signal that represents a phase offset between a reference clock signal and the first signal; and
   generating, at a digital filter, the second signal by filtering out spectral components in the third signal.

11. The method of claim 10, wherein generating the third signal comprises generating the third signal representing a fixed positive value in response to the first signal generated by the DCO representing a value greater than zero.

12. The method of claim 10 or 11, wherein generating the third signal comprises generating the third signal representing a fixed negative value in response to the first signal generated by the DCO representing a value less than zero.

13. The method of any of claims 10 to 12, further comprising:
   receiving, at the digital phase detector, the first signal as output from the DCO.

14. The method of claim 13, further comprising:
   generating, at the digital phase detector, quantization noise based on a difference between a value represented by the third signal and a value of a probability density function at the phase offset, and wherein the probability density function represents a statistical distribution of sampled phases determined based on phase noise in the reference clock signal.

15. The method of any of claims 10 to 14, further comprising:

   generating, at a frequency locked loop, FLL, connected to the DCO, a fourth signal that represents a difference between a reference frequency of a harmonic of a reference clock frequency and an output frequency of the first signal generated by the DCO; and
   modifying, at the DCO, the output frequency of the first signal based on the fourth signal.

FIG. 1

**FIG. 2**

**FIG. 3**

**FIG. 4**

**FIG. 5**

**FIG. 6**

**FIG. 7**

**FIG. 8**

FIG. 9

**FIG. 10**

EP 4 757 185 A1

European Patent Office
Europäisches Patentamt
European Patent Office
Office européen des brevets

## EUROPEAN SEARCH REPORT

**Application Number**

EP 25 21 9838

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RU Z. ET AL: "A 12GHz 210fs 6mW digital PLL with sub-sampling binary phase detector and voltage-time modulated DCO", 2013 SYMPOSIUM ON VLSI CIRCUITS IEEE, 12 June 2013 (2013-06-12), XP032474858, ISBN: 9781467355315 [retrieved on 2013-08-13] * column 1 - column 3; figures 1-5 * | 1-15 | INV. H03L7/087 H03L7/091 H03L7/10 |
| X | LIU MALIANG ET AL: "A 5-GHz Low-Power Low-Noise Integer-N Digital Subsampling PLL With SAR ADC PD", IEEE TRANSACTIONS ON MICROWAVE THEORY AND TECHNIQUES IEEE, USA, vol. 66, no. 9, 1 September 2018 (2018-09-01), pages 4078-4087, XP011689776, ISSN: 0018-9480, DOI: 10.1109/TMTT.2018.2840987 [retrieved on 2018-09-03] | 1-7, 10-15 | |
| A | * paragraph [000I] - paragraph [000V]; figures 1-19 * | 8,9 | TECHNICAL FIELDS SEARCHED (IPC) |
| X | SIRIBURANON TEERACHOT ET AL: "A 2.2 GHz $-242\;\text{dB}$-FOM 4.2 mW ADC-PLL Using Digital Sub-Sampling Architecture", IEEE JOURNAL OF SOLID-STATE CIRCUITS IEEE, USA, vol. 51, no. 6, 1 June 2016 (2016-06-01), pages 1385-1397, XP011613878, ISSN: 0018-9200, DOI: 10.1109/JSSC.2016.2546304 [retrieved on 2016-06-13] | 1-7, 10-15 | H03L |
| A | * paragraph [000I] - paragraph [00VI]; figures 1-24 * | 8,9 | |
| | -/-- | | |

The present search report has been drawn up for all claims

| Place of search | Date of completion of the search | Examiner |
|---|---|---|
| The Hague | 16 April 2026 | Rafflenbeul, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

**EUROPEAN SEARCH REPORT**

Application Number

EP 25 21 9838

## DOCUMENTS CONSIDERED TO BE RELEVANT

| Category | Citation of document with indication, where appropriate, of relevant passages | Relevant to claim |
|---|---|---|
| A | US 2017/244416 A1 (LAKSHMIKUMAR KADABA [US] ET AL) 24 August 2017 (2017-08-24) * paragraph [0001] - paragraph [0052]; figures 1-6 * ----- | 1-15 |

CLASSIFICATION OF THE APPLICATION (IPC)

TECHNICAL FIELDS SEARCHED (IPC)

The present search report has been drawn up for all claims

| Place of search | Date of completion of the search | Examiner |
|---|---|---|
| The Hague | 16 April 2026 | Rafflenbeul, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 9838

This annex lists the patent family members relating to the patent documents cited in the above-mentioned European search report.
The members are as contained in the European Patent Office EDP file on
The European Patent Office is in no way liable for these particulars which are merely given for the purpose of information.

16-04-2026

| Patent document cited in search report | Publication date | Patent family member(s) | Publication date |
|---|---|---|---|
| US 2017244416 A1 | 24-08-2017 | NONE | |

For more details about this annex : see Official Journal of the European Patent Office, No. 12/82

EPO FORM P0459